(19) Europäisches Patentamt

**European Patent Office**

Office européen des brevets

(11) Veröffentlichungsnummer: **0 002 669**
B1

(12) # EUROPÄISCHE PATENTSCHRIFT

(45) Veröffentlichungstag der Patentschrift:
28.10.81

(51) Int. Cl.³: **H 01 L 21/316**

(21) Anmeldenummer: 78101460.0

(22) Anmeldetag: 27.11.78

(54) **Verfahren zum Entfernen von Material von einem Substrat durch selektive Trockenätzung und Anwendung dieses Verfahrens bei der Herstellung von Leitungsmustern.**

(30) Priorität: 20.12.77 US 862262

(43) Veröffentlichungstag der Anmeldung:
11.07.79 Patentblatt 79/14

(45) Bekanntmachung des Hinweises auf die Patenterteilung:
28.10.81 Patentblatt 81/43

(84) Benannte Vertragsstaaten:
DE FR GB

(73) Patentinhaber: **International Business Machines Corporation, Armonk, N.Y. 10504 (US)**

(72) Erfinder: **Schaible, Paul Martin, 46 Hillis Terrace, Poughkeepsie NY 12603 (US)**
Erfinder: **Schwartz, Geraldine Cogin, 19 Woodward Road, Poughkeepsie NY 12603 (US)**
Erfinder: **Rothman, Laura Beth, Holiday Point, Sherman, Connecticut 06784 (US)**

(74) Vertreter: **Böhmer, Hans Erich, Dipl.-Ing., Schönaicher Strasse 220, D-7030 Böblingen (DE)**

(56) Entgegenhaltungen:
US-A-3 692 655
US-A-3 873 361
US-A-3 982 943
US-A-3 994 793
US-A-4 004 044
IBM Technical Disclosure Bulletin
Vol. 19, No. 11, April 1977,
Armonk, N.Y. USA,
R. A. Unis «Fabrication process for narrow line separation»

(56) Entgegenhaltungen:
Seiten 4089 bis 4090
Vakuum-Technik
24. Jg., Heft 6, September 1975,
Idstein/Taunus
R. Wechsung u.a.
«Anwendung des Ionen-Ätzens zur Erzeugung feiner Strukturen in dünnen Schichten»
Seiten 157 bis 166

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Verfahren zum Entfernen von Material von einem Substrat durch selektive Trockenätzung und Anwendung dieses Verfahrens bei der Herstellung von Leitungsmustern

Die Erfindung betrifft ein Verfahren zum Entfernen von Material von einem Substrat durch selektive Trockenätzung, bei welchem vor dem Ätzverfahren eine das Substrat unmittelbar überdeckende Maske auf einer Oberfläche des Substrats unter Freilegung diskreter Flächen dieser Oberflächen gebildet wird.

Beschreibung des Standes der Technik

Aluminium und Aluminiumlegierungen werden für metallische Leitungen und Leitungsverbindungen sowie Leitungsmuster in integrierten Schaltungen in grossem Umfange benutzt, und die Herstellung von Schaltungen erfordert Verfahren zur Abgrenzung von Mustern in metallischen, dünnen Schichten zur Erzielung des gewünschten Leitungsmusters. Mit zunehmender Schaltungsdichte werden die metallischen Verbindungsleitungen immer schmaler und haben einen immer geringeren Abstand. Ausserdem muss bei Anwendungsgebieten in hoch integrierten Schaltungen die metallische Schicht oder das Muster gewöhnlich viel dicker sein, um ausreichend hohe Ströme aufnehmen zu können.

Diese Forderungen können durch übliche chemische subtraktive Ätzverfahren für die Definition von metallischen Leitungsmustern nicht erfüllt werden, so dass in den letzten Jahren das Interesse an Trockenätzverfahren für die Herstellung von Metallisierungsmustern bei integrierten Schaltungen ständig zugenommen hat. Einige Trockenätzverfahren werden da eingesetzt, wo die Seitenwände des geätzten Musters genau senkrecht sein müssen. Solche gerichtete Ätzverfahren sind beispielsweise Ionen-Beschuss und/oder durch Ionen unterstützte chemische Reaktionen: Hochfrequenz-Zerstäubungsätzen, Ionenstrahlätzen und reaktives Ionenätzen, (das auch manchmal reaktives Zerstäubungsätzen genannt wird.

Ein derartiges reaktives Ionenätzverfahren ist beispielsweise aus der US-PS 3 994 793 bekannt. Dort wird eine auf einem Substrat liegende maskierte Aluminiumschicht einem Plasma ausgesetzt, das durch Anlegen einer hochfrequenten Spannung an eine Atmosphäre gebildet wird, die $CCl_4$, $Cl_2$, $Br_2$ oder HCl enthält. Das Aluminium, das dabei mit Chlor- oder Bromionen bombardiert wird, reagiert unter Bildung einer Aluminiumchlorid- oder Aluminiumbromidverbindung, die bei der Temperatur des Substrats flüchtig ist. Die Maskenschicht besteht dabei aus einem Photolack, $SiO_2$, $Al_2O_3$ oder $Si_3N_4$.

Ferner ist es aus der US-PS 3 692 655 bekannt, beim Hochfrequenz-Zerstäubungsätzen eine vorzeitige Zerstörung einer Photolackmaske dadurch zu verhindern, dass das Substrat auf einer Platte aus beispielsweise MgO, $SiO_2$ oder $Al_2O_3$ angebracht wird und während des Ätzens auch das Material der Platte abgeätzt wird und sich auf der Photolackschicht niederschlägt.

Alle diese Verfahren verwenden ein Gasplasma, das durch das Anlegen einer hochfrequenten Spannung angeregt wird. Der Frequenzbereich liegt meist zwischen 13,56 und 40,63 MHz, jedoch werden auch andere Frequenzen benutzt.

Ein weiteres Trockenätzverfahren, das reaktive Plasmaätzen, wird eingesetzt, um nasse Ätzverfahren zu vermeiden und um ein Unterätzen der Maske zu verhindern. Dieses Verfahren ist ein chemisches Ätzverfahren mit freien Radikalen und ist isotrop. Freie Radikale werden in einem durch Anlegen einer hochfrequenten Spannung, gewöhnlich entweder 50 KHz oder 13,56 MHz, angeregten Plasma erzeugt, es können jedoch auch andere Hochfrequenzen benutzt werden. Ferner wurde auch Anregung durch Mikrowellen eingesetzt.

Derartige Verfahren werden für die Ätzung von Metallisierungs-Leitungsmustern, Kontaktbohrungen, durchgehende Bohrungen in $SiO_2$, $Si_3N_4$, Polyimid und dergleichen und ausserdem zum Ätzen von tiefen Nuten oder Gräben in Silicium für Isolationszwecke und zum Ätzen von tiefen Löchern in Silicium oder Silidiumdioxid für Tintenstrahldrucker oder dergleichen benutzt.

Bei diesen Trockenätzverfahren wird die zu ätzende Oberfläche mit einer Maske überzogen und dann dem Trockenätzverfahren ausgesetzt. Bei gerichteten Ätzverfahren muss die Maske insbesondere dann, wenn genau senkrechte Seitenwände erzielt werden sollen und insbesondere dann, wenn geringe Abmessungen und/oder tiefes Ätzen erforderlich sind, verschiedene Forderungen erfüllen, d.h. das Ätzverfahren darf nicht mit merklicher Geschwindigkeit ablaufen und darf nicht die Bildung von Rückständen durch Rückstreuen bewirken, darf das Plasma nicht verschlechtern, darf bei erhöhten Temperaturen nicht fliessen oder sich verformen, welche Temperaturen entweder durch Ionen-Bombardierung hervorgerufen sind, oder aber für eine Erhöhung der Flüchtigkeit der Reaktionsprodukte bei Plasmareaktionen vorgesehen sind, und muss über das ganze Leitungsmuster zur Herstellung einer gleichförmigen Dicke reproduzierbar sein, um damit eine Verschlechterung an den Kanten zu verhindern. Beim Plasmaätzen müssen alle diese Bedingungen, mit Ausnahme der Auswirkungen durch Ionen-Beschuss ebenfalls erfüllt werden. Ferner soll dann, wenn geringe Abmessungen erforderlich sind, das Maskenverfahren auch mit der Elektronenstrahl-Lithographie verträglich sein. Ferner sollte sich die Maske vollständig entfernen lassen, ohne dass dadurch das geätzte Muster oder das darunterliegende Substrat angegriffen werden. Für eine Brauchbarkeit bei industriellen Fertigungsverfahren sollte das Abziehen der Maske in relativ kurzer Zeit erreichbar sein und vorzugsweise in einer nicht korrodierenden Umgebung vor sich gehen.

In dieser Hinsicht gibt es bei der Abgrenzung von metallischen Leitungsmustern aus Aluminium oder dessen Legierungen, mit denen sich die vorliegende Erfindung befasst, zwei schwerwiegende Probleme bei einem trockenen Ätzverfahren, insbesondere beim Ätzen solcher Muster aus Aluminium-Kupfer-Legierungen durch reaktives Ionenätzen. Die erste Schwierigkeit besteht darin, dass die derzeit benutzten Masken während des Ätzens der Metallisierung tatsächlich mit ziemlich hoher Geschwindigkeit abgeätzt werden und dass dadurch eine Verschlechterung des Metallisierungsmusters auftritt. Die zweite Schwierigkeit besteht darin, dass einige der Maskenverfahren mit der Elektronenstrahl-Lithographie nicht vollständig verträglich sind: Die Verwendung von dicken Photolackschichten führt zur Aufladung und zu Ausrichtschwierigkeiten während der Belichtung, und während der Entwicklung gibt es Schwierigkeiten wegen der unterschiedlichen Löslichkeit. Keines der bekannten Maskenverfahren, wie zum Beispiel die Verwendung von Lacken und Photolacken verschiedener Arten, einschliesslich der mit verschiedenen Oberflächenmodifikationen, sowie die Benutzung subtraktiv geätzter Oxide und Aluminium-Oxide erfüllt alle diese Bedingungen.

Gesamtdarstellung der Erfindung

Aufgabe der Erfindung ist es daher, ein neuartiges trockenes Maskenätzverfahren für Substrate zu schaffen, wobei die dabei verwendete Ätzmaske in der Trockenätzumgebung im wesentlichen inert ist. Insbesondere soll dabei eine neuartige Ätzmaske geschaffen werden, die in einer Trockenätzumgebung nicht merklich sich verschlechtert. Darüber hinaus soll dabei auch die Bildung von Rückständen durch Rückstreuung vermieden werden.

Ferner soll erreicht werden, dass die neuartige Maske bei dem Trockenätzverfahren bei erhöhten Temperaturen nicht fliesst und sich nicht verformt und ausserdem mit Elektronenstrahl-Lithographie voll verträglich ist. Ausserdem soll sich die neuartige Ätzmaske für ein Trockenätzverfahren vollständig und schnell in einer im wesentlichen nicht korrodierenden Umgebung abziehen lassen.

Demgemäss wird ein Verfahren zum Entfernen von Material von einem Substrat durch selektive Trockenätzung geschaffen, bei welchem vor dem Ätzverfahren eine das Substrat unmittelbar überdeckende Maske auf einer Oberfläche des Substrats unter Freilegung diskreter Flächen dieser Oberfläche gebildet wird, bei welchem gemäss der Erfindung als Maskenmaterial MgO verwendet wird.

Es wurde dabei festgestellt, dass eine aus Magnesiumoxid (MgO) bestehende Maske beim Trockenätzen von Substraten und/oder darauf befindlichen dünnen Schichten alle oben erwähnten Forderungen erfüllt. Das Magnesiumoxid kann auf einem Substrat durch Öffnungen einer dünnen abziehbaren Maske hergestellt werden, die anschliessend entfernt wird. Derartige Abziehverfahren sind bekannt und sind beispielsweise in den US-Patentschriften 3 421 206, 3 873 361, 3 934 057, 3 982 943 und 4 004 044 beschrieben.

Andererseits kann in der aus Magnesiumoxid bestehenden Schicht durch subtraktives Ätzen ein Muster hergestellt werden. Eine dünne Schicht aus MgO wird auf dem Substrat niedergeschlagen. Das gewünschte Muster wird dann in einer relativ dünnen Schicht aus Photolack entweder durch ein optisches oder Elektronenstrahl-Lithographieverfahren definiert. Die nicht-maskierten MgO-Bereiche werden in einer gesättigten Lösung von Ammonium-Oxalat bei Zimmertemperatur geätzt, worauf die Photolackschicht in üblicher Weise entfernt wird.

Für die Herstellung von Halbleiterschaltungen wird gemäss der Erfindung eine alles überdeckende Schicht aus einem elektrisch leitenden Material, wie z.B. eine Aluminium-Kupfer-Legierung durch Aufdampfen oder Kathodenzerstäubung über einer integrierten Schaltung niedergeschlagen, die isolierende Schicht, wie z.B. Silicium-Dioxid enthält. Daraufhin wird, alles überdeckend, eine organische Polymerschicht aufgebracht, wie z.B. ein Photolack, der anschliessend belichtet und entwickelt wird, wobei übliche photolithographische Verfahren oder Elektronenstrahl-Lithographie-Verfahren angewandt werden, wodurch ein Muster von Öffnungen entsprechend dem gewünschten Leitungsmuster hergestellt wird. Anschliessend wird durch Verdampfung über dem verbliebenen Photolack und der freiliegenden metallischen Schicht eine alles überdeckende Schicht aus Magnesium-Oxid niedergeschlagen, worauf durch ein geeignetes Lösungsmittel die restlichen Teile des Photolacks zusammen mit der darüberliegenden Schicht aus Magnesium-Oxid entfernt werden. Dadurch erhält man eine aus Magnesium-Oxid bestehende Maske, die dem gewünschten Metallisierungsmuster entspricht. Das in den Öffnungen der MgO-Maske freiliegende Metall wird dann durch Trockenätzverfahren entfernt, worauf dann die MgO-Maske in einem Lösungsmittel, wie z.B. einer Lösung aus Oxalsäure, Ammonium-Oxalat, Essigsäure und dergleichen entfernt wird.

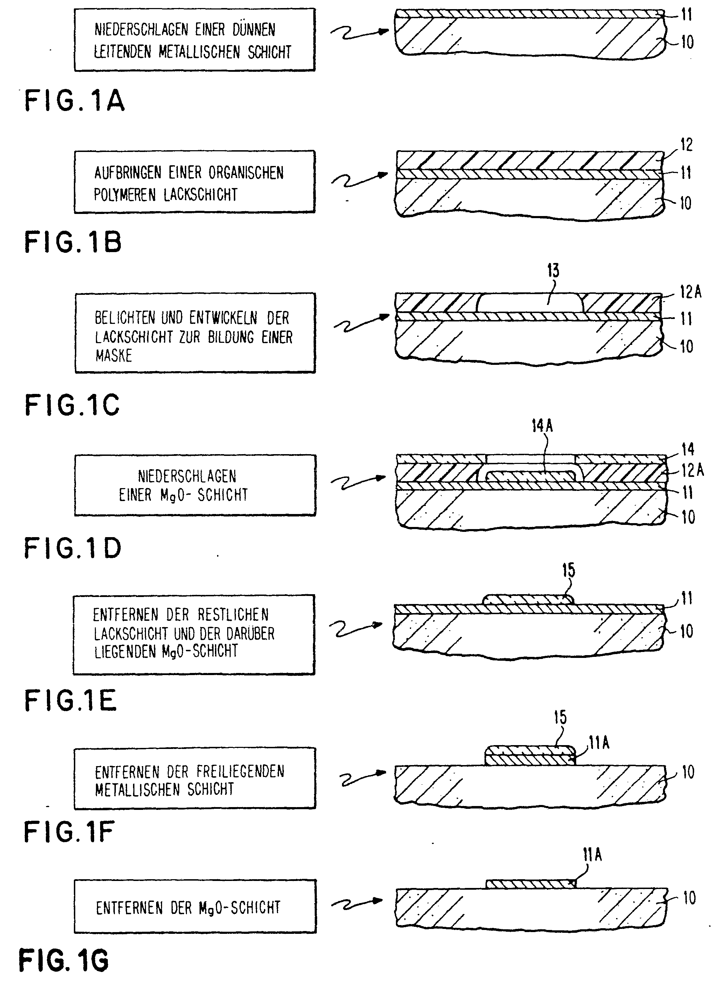

Die Erfindung wird nunmehr anhand der Fig. 1 mit den Teilfiguren 1A–1G in Verbindung mit einer bevorzugten Ausführungsform und einem die verschiedenen Verfahrensschritte beschreibenden Flussdiagramm im einzelnen beschrieben.

Beschreibung der bevorzugten Ausführungsform

In Fig. 1A wird ein Substrat 10 verwendet, das aus einer Silicium-Dioxidschicht bestehen kann, die auf einem Halbleiterplättchen (nicht gezeigt) während der Herstellung gebildet wurde. Normalerweise enthält eine solche Halbleiterscheibe mindestens eine, in üblicher Weise hergestellte integrierte Schaltung einschliesslich ohmscher Kontakte (die nicht gezeigt sind).

Als nächstes wird eine aus einem leitenden Metall bestehende, alles überdeckende Schicht durch Niederschlag im Vakuum, Kathodenzerstäubung oder dergleichen über der Oberfläche der Struktur niedergeschlagen. Diese metallische Schicht kann aus jedem üblicherweise für Metallisierungen in integrierten Schaltungen verwendeten Metall bestehen, wie zum Beispiel aus Aluminium, Aluminium-Kupfer-Legierungen, Platin, Palladium, Tantal, Chrom, Wolfram, Titan, Gold, Hafnium und dergleichen. Nur zur Erläuterung soll diese metallische Schicht 11 eine etwa 1000 nm oder 1 μm dicke Schicht aus einer Aluminium-Kupfer-Legierung aus 96% Kupfer und 4% Aluminium sein.

Als nächstes wird über der metallischen Schicht 11 eine Schicht 12 aus einem abziehbaren Maskenmaterial aufgebracht. Dieses Maskenmaterial ist als organisches, polymeres Material gekennzeichnet, das beispielsweise ein Photolack oder ein Elektronenstrahl-Lack sein kann, der in üblicher Weise beispielsweise durch Schleudern als Überzug aufgebracht werden kann. Wie angegeben, kann der Lack aus einem für optische Belichtung oder für Belichtung durch Elektronenstrahl empfindlichen Photolack bestehen, d.h. ein durch Bestrahlung sich verändernder Photolack einschliesslich Zwei-Schichten Polymethylmethacrylat-Polymere, copolymere Photolacke und dergleichen, wie sie in den oben genannten Patentschriften für Abziehverfahren beschrieben sind. Andere geeignete Photolacke sind Shipley AZ-1350J, Kodak KTFR, synthetische Harze wie Polyvinyl Cinnamat, Diazo-Photolacke und dergleichen.

Dieses Maskenmaterial wird zu einer Abziehmaske 12A mit einem Muster von Öffnungen 13 gemäss Fig. 1C durch Belichtung und Entwicklung mit üblichen lithographischen Verfahren verarbeitet, die bei der Herstellung integrierter Schaltungen bekannt sind.

Beim nächsten Arbeitsschritt wird eine 200 nm oder 0,2 μm dicke Schicht 14 aus Magnesium-Oxid auf der Oberseite der abziehbaren Maske 12A und der freiliegenden Teile der metallischen Schicht 11, wie dies durch die Segmente 14A angedeutet ist, aufgedampft, die dann schliesslich die aus MgO bestehende Trockenätzmaske 15 bilden.

Anschliessend werden die verbleibenden Teile der Photolackmaske 12A unter Verwendung üblicher Abziehverfahren durch Lösungsmittel oder Ätzmittel vollständig entfernt, wodurch auch die darüberliegende Magnesium-Oxid-Schicht entfernt wird, so dass nur die Magnesium-Oxid-Segmente 14A übrig bleiben, die auf der Oberfläche der metallischen Schicht 11 eine Trockenätzmaske 15 bilden. Ein positiver Photolack, wie z.B. AZ-1350J, kann durch Eintauchen in ein Lösungsmittel, wie z.B. N-Methylpyrrolidon entfernt werden. Normalerweise ist es lediglich erforderlich, dass das Lösungsmittel das polymere Material auflöst oder zum Quellen bringt, ohne dass dabei das Magnesium-Oxid-Material oder die metallische Schicht beeinflusst wird. Andere brauchbare Lösungsmittel sind Azeton, Butylacetat, Trichloräthylen, Cellosolve-Azetat (Warenzeichen) und dergleichen.

Die aus Magnesium-Oxid bestehende Maskenstruktur wird dann für die Entfernung der freiliegenden Abschnitte der metallischen Schicht 11 bis auf das Substrat 10 einem Trockenätzverfahren ausgesetzt. Beispielsweise kann die Struktur durch ein reaktives Ionen-Ätzen bei 0,3 Watt/cm$^2$ bei 27 MHz in einer Atmosphäre von $CCl_4$/Ar gemäss US-Patentschrift 3 994 793 trocken geätzt werden.

Nach dem Trockenätzen der freiliegenden metallischen Schicht wird die Magnesium-Oxid-Maske 15 durch ein Lösungsmittel oder Ätzmittel entfernt, beispielsweise durch Eintauchen für 2 Minuten in eine warme (40–50 °C) 8%ige wässrige Lösung von Oxalsäure.

Durch Entfernen der Magnesium-Oxid-Maske 15 erhält man die maskierten Teile der metallischen Schicht 11 in der gewünschten Form des Musters 11A.

Es sei darauf verwiesen, dass die Erosionsgeschwindigkeit der Magnesium-Oxid-Maske in einem $CF_4$–, $CCl_4$/Ar–, $Cl_2$/Ar– und Ar– Plasma sehr gering ist, wie dies die Tabelle I zeigt, und unerwartet viel langsamer als die Erosionsgeschwindigkeit bei $Al_2O_3$.

Tabelle I

| Abtraggeschwindigkeiten (nm/Minute) Trockenätzverfahren | | Maskenmaterial | | |
|---|---|---|---|---|
| | | MgO | $SiO_2$ | $Al_2O_3$ |
| 1,6 W/cm$^2$, 50μ(6·50 Pa)Ar, | 13,56MHz | 1,5 | 6,5 | 2,5 |
| 1,6 W/cm$^2$, 50μ(6·50 Pa)$CF_4$, | 13,56MHZ | 5,0 | 100 | 20 |
| 0,3 W/cm$^2$, 2μ(0·26 Pa)$CCl_4$/8μ(1·04 Pa)Ar, | 27,0 MHz* | 2,0 | 20 | 10 |

* Reaktives Ionen-Ätzverfahren gemäss US-Patent 3 994 793

In der Literatur (z.B. H. Bach, Naturwissenschaften, 1969, 55 (9), Seite 439) wird berichtet, dass in einem 5,6 Kev Ar$^+$-Strahl Magnesium-Oxid mit der doppelten Geschwindigkeit von $Al_2O_3$ ätzt und etwa mit derselben Geschwindigkeit wie Quarz. In Zerstäubungssystemen liegen die Energien im Bereich um 500 Volt. Jeder Versuch, eine rationelle Grundlage für die Zerstäubungsgeschwindigkeiten von Verbindungen in der Literatur zu finden, führt auf eine Beziehung zwischen der Zerstäubungsausbeute und Verbindungswärme der Verbindung, d.h. die geringe Zerstäubungsausbeute von $Al_2O_3$ wird durch die hohe negative Bildungswärme der Verbindung erklärt. Auf dieser Grundlage ist die niedrige Zerstäubungsgeschwindigkeit von MgO bei den niederigeren Energien der Zerstäubungssysteme (verglichen mit dem oben erwähnten Ionenstrahl) völlig unerwartet. Selbst wenn man eine Umwandlung des Oberflächenoxids in das entsprechende Halogenid in einem halogenhaltigen Plasma annehmen würde und die relativen Bildungswärmen als Grundlage für eine Voraussage über die Zerstäubungsgeschwindigkeiten der nicht-flüchtigen Halide untersuchen würde, dann hätten Aluminium-Verbindungen die geringeren Erosionsgeschwindigkeiten.

Da die Erosionsgeschwindigkeit sehr gering ist, reicht eine MgO-Schicht mit einer Dicke von 200 nm für die meisten Zwecke, d.h. für die Bildung von Verbindungsleitungsmustern, Isolationsvertiefungen in Silicium und Löchern in dielektrischen Materialien aus. Das heisst aber, dass der abzuziehende Photolack ziemlich dünn sein kann (annähernd 700 nm). Dadurch verringern sich die bei der Elektronenstrahl-Belichtung auftretenden Aufladungsschwierigkeiten, die bei der Entwicklung mit Elektronenstrahl auftretenden Schwierigkeiten werden klein gehalten, und man erhält eine bessere Definition des Leitungsmusters. Ein weiterer Vorteil der Verwendung einer dünnen Schicht aus MgO besteht darin, dass bei subtraktivem Ätzen von MgO eine sehr enge Anlehnung an die Photolackmaske erfolgt.

MgO ist eine anorganische Verbindung mit einem Schmelzpunkt von 2852 °C, so dass während des Trockenätzens kein Fliessen, keine Verformung oder keine Verschlechterung der MgO-Schicht eintritt. Die dünne MgO-Schicht ist trotz ihrer geringen Stärke frei von feinsten Löchern, den sogenannten «pinholes». Keine Photolackschicht ist dabei dem Plasma ausgesetzt, sie werden alle vor dem Ätzen leicht abgezogen. Wird die Oberfläche des MgO in einem halogenhaltigen Plasma in das entsprechende Halogenid umgewandelt, dann ist das Fluorid nicht flüchtig und das Chlorid hat einen Dampfdruck, der wesentlich kleiner ist als der von Aluminium und Kupfer-Chlorid. Man würde daher keine wesentlichen Verluste durch Verdampfung erwarten. Es hat jedoch den Anschein, dass es die unerwartet niedrige Zerstäubungsgeschwindigkeit der Oberflächenschichten ist, die hier besondere Bedeutung hat, da keine Rückstände durch Rückwärtsstreuung auftreten, wie man sie beispielsweise im Falle einer Aluminium-Maske während eines Trockenätzverfahrens von $SiO_2$ in $CF_4$ durch reaktives Ionenätzen feststellt.

Da die MgO-Maske entweder durch ein Abziehverfahren oder ein subtraktives Ätzverfahren beim Trockenätzen von metallischen Verbindungsleitungsmustern hergestellt werden kann, lässt sich das Muster immer durch positives Einschreiben mittels Elektronenstrahl in einem positiven Lack bilden. Der Musterfaktor bestimmt dabei, ob ein Ablösemuster oder ein subtraktives Ätzmuster geschrieben werden soll. Daraus ergibt sich für Elektronenstrahl-Lithographie ein kostenmässiger und/oder durchsatzmässiger Vorteil.

MgO ist in Oxalsäure lösbar, d.h. einer nichtkorrodierenden Säure (im Hinblick auf die Abfallbeseitigung). Metalle wie z.B. Al, Cu, Cr, Ti, W, Ta, Au usw. und Silicium, $SiO_2$, $Si_3N_4$, Polyimid usw. werden durch Oxalsäure nicht geätzt, so dass das Entfernen der Maske sicher und schnell und ohne Nachteile für die Umgebung vor sich geht.

Die Verwendung einer nicht erodierenden, transparenten Maske aus MgO macht es ferner möglich, einfache interferometrische Verfahren zur Überwachung der Ätzgeschwindigkeiten von undurchsichtigen Materialien am Ort zu überwachen. Da MgO eine sehr kleine Zerstäubungsätzgeschwindigkeit in Argon aufweist, kann es beim Zerstäubungsätzen und Ionen-Abtragen wie auch beim reaktiven Ionen-Ätzen eingesetzt werden.

Obgleich andere Materialien wie $Al_2O_3$, $SiO_2$ und SiO durch eine abziehbare Maske niedergeschlagen werden und in RIE benutzt werden können (nur $Al_2O_3$ ist als Maske in einem $CF_4$-Plasma brauchbar, während alle in chlorinierten Plasmas brauchbar sind), so ist MgO das einzige Material, das voraussichtlich mit Metallen benutzt werden kann. Niedergeschlagenes $Al_2O_3$ ist kristallin und ist unter den hier benutzten Niederschlagsbedingungen in Phosphorchrom-Säure lösbar, könnte aber unter anderen Umständen eine mehr geordnete Struktur erhalten, wodurch es in dem Ätzmittel, das Aluminium nicht angreift, unlösbar würde. Das $SiO_2$ erfordert für seine Auflösung gepufferte HF, und dies kann das Substrat und auch möglicherweise das Metall angreifen. $SiO_2$ ist nur in Lösungen aus $HF/HNO_3$ lösbar, die ebenfalls das Substrat angreifen können. Ausserdem führen die höheren Erosionsgeschwindigkeiten zu der Forderung, das für gleichmässigen Schutz dickere Masken erforderlich wären, wenn sie anstelle von MgO benutzt würden. Dies kann auch die Verwendung von dickeren Photolackschichten zur Folge haben, mit den sich dabei ergebenden Schwierigkeiten. Daher ist MgO für Trockenätzverfahren ein einmalig geeignetes Material.

## Patentansprüche

1. Verfahren zum Entfernen von Material von einem Substrat durch selektive Trockenätzung, bei welchem vor dem Ätzverfahren eine das Substrat unmittelbar überdeckende Maske auf einer Oberfläche des Substrats unter Freilegung diskreter Flächen dieser Oberfläche gebildet wird, dadurch gekennzeichnet, dass als Maskenmaterial MgO verwendet wird.

2. Verfahren nach Anspruch 1, dadurch gekennzeichnet, dass als Substrat eine Halbleiterscheibe verwendet wird.

3. Verfahren nach den Ansprüchen 1 oder 2, dadurch gekennzeichnet, dass das Material durch reaktives Ionen-Ätzen entfernt wird.

4. Verfahren nach Anspruch 1, dadurch gekennzeichnet, dass als Substrat eine Siliciumschicht, eine dielektrische Schicht oder eine aus Aluminium oder Aluminium-Legierungen bestehende elektrisch leitende Metallschicht verwendet wird.

5. Anwendung eines Verfahrens nach den Ansprüchen 1–4 zum Herstellen eines Leitungsmusters auf Halbleiterschaltungen, gekennzeichnet durch folgende Verfahrensschritte:

– Niederschlagen eines Films eines leitenden Metalls auf der Oberfläche eines Halbleitersubstrats mit mindestens einer darin gebildeten integrierten Schaltung,

– Herstellen einer ersten Maskenschicht eines organischen, polymeren Materials auf dieser Schicht, mit einem vorbestimmten Muster von darin angebrachten Öffnungen zur Freilegung entsprechender Teile der Schicht,

– Niederschlagen einer Schicht aus Magnesiumoxid auf der Maskenschicht und dem freiliegenden Teil der metallischen Schicht,

– Entfernen der Maskenschicht und der Teile der darauf niedergeschlagenen Oxidschicht zur Bildung einer verbleibenden Maske als Muster des Oxids auf dieser Schicht, mit Öffnungen über der metallischen Schicht, die komplementär zu dem Muster von Öffnungen in der ersten Maskenschicht sind,

– Entfernen der Teile der metallischen Schicht, die durch die Oxidmaske freiliegend und

– Entfernen der Oxidmaske.

## Revendications

1. Procédé pour enlever un matériau d'un substrat par décapage à sec sélectif, dans lequel on forme, avant le procédé de décapage, un masque recouvrant directement le substrat sur une surface du substrat en exposant des régions discrètes de cette surface, caractérisé en ce que le matériau de masque utilisé est du MgO.

2. Procédé selon la revendication 1, caractérisé en ce que l'on utilise comme substrat une tranche semi-conductrice.

3. Procédé selon la revendication 1 ou 2, caractérisé en ce que le matériau est enlevé par décapage ionique réactif.

4. Procédé selon la revendication 1, caractérisé en ce que l'on utilise comme substrat une couche de silicium, une couche diélectrique, ou une couche métallique électriquement conductrice composée d'aluminium ou d'alliages d'aluminium.

5. Utilisation d'un procédé selon l'une des revendications 1 à 4, pour fabriquer une configuration de conducteurs sur des circuits semi-conducteurs, caractérisée par les étapes de procédé suivantes:

dépôt d'une pellicule d'un métal conducteur sur la surface d'un substrat semi-conducteur ayant au moins un circuit intégré formé dans celle-ci, formation sur cette couche d'une première couche de masquage d'un matériau polymère organique, ayant une configuration prédéterminée d'ouvertures pratiquées dans celle-ci pour exposer les parties correspondantes de la couche,

dépôt d'une couche d'oxyde de magnésium sur la couche de masquage et la partie exposée de la couche métallique,

enlèvement de la couche de masquage et des parties de la couche d'oxyde déposées sur celle-ci pour former un masque restant en tant que configuration d'oxyde sur cette couche, avec des ouvertures au-dessus de la couche métallique qui sont complémentaires à la configuration d'ouvertures dans la première couche de masquage, enlèvement des parties de la couche métallique exposée par le masque d'oxyde, et

enlèvement du masque d'oxyde.

## Claims

1. Process for the selective removal of material from a substrate by means of dry etching, wherein prior to the etching process a mask directly covering the substrate is formed on a surface of the substrate, exposing discrete areas of this surface, characterized in that MgO is used as mask material.

2. Process as claimed in claim 1, characterized in that a semiconductor wafer is used as a substrate.

3. Process as claimed in claims 1 or 2, characterized in that the material is removed by means of reactive ion etching.

4. Process as claimed in claim 1, characterized in that as a substrate a silicon layer, a dielectric layer, or an electrically conductive metal layer consisting of aluminium or aluminium alloys is used.

5. Application of a process as claimed in any one of claims 1 to 4 for making a conductive pattern on semiconductor circuits, characterized by the following process steps:

depositing a film of a conductive metal on the surface of a semiconductor substrate having at least one integrated circuit formed therein, forming on said film a first masking layer of an organic polymeric material having a predetermined pattern of openings therein exposing corresponding portions of said film,

depositing a layer of magnesium oxide on said masking layer and on the exposed portion of said metal film,

removing said masking layer and the portions of said oxide layer deposited thereon to form a retained mask as a pattern of the oxide on said film, having openings over said metal film which are complementary to the pattern of openings in the first masking layer,

removing the portions of said metal film exposed by the oxide mask, and

removing said oxide mask.

| NIEDERSCHLAGEN EINER DÜNNEN LEITENDEN METALLISCHEN SCHICHT |
|---|

FIG.1A

| AUFBRINGEN EINER ORGANISCHEN POLYMEREN LACKSCHICHT |
|---|

FIG.1B

| BELICHTEN UND ENTWICKELN DER LACKSCHICHT ZUR BILDUNG EINER MASKE |
|---|

FIG.1C

| NIEDERSCHLAGEN EINER MgO- SCHICHT |
|---|

FIG.1D

| ENTFERNEN DER RESTLICHEN LACKSCHICHT UND DER DARÜBER LIEGENDEN MgO-SCHICHT |
|---|

FIG.1E

| ENTFERNEN DER FREILIEGENDEN METALLISCHEN SCHICHT |
|---|

FIG.1F

| ENTFERNEN DER MgO-SCHICHT |
|---|

FIG.1G